# EUROPEAN PATENT SPECIFICATION

(11) **EP 0 441 905 B1**
(45) Date of publication and mention of the grant of the patent: **06.09.1995**
(21) Application number: 90908390.9
(22) Date of filing: 04.05.1990
(51) Int. Cl.: H05H 1/24, H05H 1/52

(54) **METHOD AND APPARATUS FOR PROCESSING MATERIALS**
VORRICHTUNG UND VERFAHREN ZUR BEHANDLUNG VON MATERIALIEN
PROCEDE ET APPAREIL DE TRAITEMENT DE MATIERES

(30) Priority: 04.05.1989 US 347422; 24.10.1989 US 425865
(43) Date of publication of application: 21.08.1991
(73) Proprietor: THE REGENTS OF THE UNIVERSITY OF CALIFORNIA, Alameda, California 94501 (US)
(72) Inventor: JOHN, F., Asmus, La Jolla, CA 92037 (US); RALPH, H., Lovberg, San Diego, CA 92116 (US)
(74) Representative: Spall, Christopher John
(86) International application number: US9002480
(87) International publication number: WO9013910

(56) References cited:
- WO-A-89/05515
- US-A- 4 088 966
- US-A- 4 369 514
- US-A- 4 450 568
- US-A- 4 454 835
- US-A- 4 522 657
- US-A- 4 525 382
- US-A- 4 624 736
- US-A- 4 635 282
- US-A- 4 718 974
- ATOMKERNENERGIE, vol. 28, no. 3, 1976, pages 150-154, München, DE; W. LOCHTE-HOLTGREVEN: "Nuclear fusion in very dense plasmas obtained from electrically "exploded" liquid threads"

## Description

### Technical Field

The present invention relates in general to a method of surface treating materials, and it more particularly relates to such a system and method for treating a material surface in an improved manner, by utilizing intense ultraviolet light radiation.

### Background Art

In the manufacture of semiconductor chips, there are various steps in the process. One step relates to circuitizing or etching of the semiconductor material to implement the integrated circuit design. While the prior known techniques employed to accomplish such a step in the process may have been satisfactory for some applications, there have been attempts proposed for improving the circuitizing step in the manufacturing process.

One proposed attempt has been to utilize X-ray radiation to achieve the circuitizing step. Such an approach has proven to be costly, and is currently undergoing further research and development work in an attempt to achieve the desired results.

In general, conventional semiconductor etching techniques generally include exposing a photoresist-coated substrate to an impinging light beam. However, with the ever increasing miniaturization of the semiconductor integrated circuitry, the size of circuit details are becoming so small that they are of a similar order of magnitude as the size of the wavelength of the impinging light beam itself. Thus, the impinging light becomes diffracted, and irregularities in the resulting product can occur.

Furthermore, due to the relatively low intensity of nonlaser sources of impinging light, the required exposure time is extended so as to convey the necessary energy for use in the etching process. Thus, the etching process is not only delayed, but the risk of impurities infiltration is increased substantially.

Therefore, there is a need for an incoherent light source system and a method of using it, which further render the semiconductor etching processes compatible with modern techniques. In this regard, undesirable diffraction caused by impinging coherent light beams would be greatly reduced, if not minimized.

Thus, at the present time, there has not been any approach which has proven to be an improvement in circuitizing semiconductors, in a more effective and efficient manner. Clearly, there has not been even a suggestion of a cost effective approach, which should constitute an improvement in present day technology, employing mass production techniques.

In another stage in the manufacturing process of semiconductors, such as semiconductor chips, semiconductor materials, in the form of thin wafers, must be annealed. In such a step in the overall process, the resulting annealed wafer has not been annealed in an entirely satisfactory manner. In this regard, in prior known annealing steps, it has been recognized the importance of uniformity in the activation in the wafer to be annealed, of the semiconductor implanted dopants, such as boron, over an entire semiconductor wafer surface.

In the past, such dopant activation has been achieved by a steady-state furnace annealing method, wherein a semiconductor wafer implanted with a dopant is placed in an annealing oven. The temperature of the oven is then slowly raised in a controlled manner for a long period of time, such as one half of an hour. After maintaining the temperature at a desired elevated temperature, the temperature of the oven is then decreased slowly and controllably for another long period of time, such as another one half hour period. Thereafter, the annealed semiconductor wafers are removed from the oven.

While the steady-state furnace annealing method may be satisfactory for some applications, it has not proven entirely acceptable in the manufacturing of certain semiconductor circuits and devices. In this regard, state of the art semiconductor devices and circuits have become increasingly smaller in size, such as about 1 µm. As these dimensions diminished in size, the need to form shallower semiconductor junctions with minimal dopant diffusion, has increased. It has been found, however, that dopants, such as boron, tend to diffuse rapidly during the high temperature annealing process used in the steady-state furnace method. Thus, the consequent redistribution of the dopant has exceeded the limits of acceptability for at least some MOS-VLSI devices, and especially high speed devices which require higher dopant doses.

In order to reduce or minimize the amount of redistribution of the dopant, several different techniques have been attempted. One such attempted technique includes using a halogen arc lamp to heat and anneal the semiconductor wafer rapidly. While such an approach employing a halogen lamp has shown that full activation of moderate dose implants of boron, could be achieved at temperatures of 1000°C in about ten seconds, it has proven to be less than totally satisfactory, particularly where higher dose dopants have been required. In this regard, it was found that uniformity of activation was unacceptable in higher doses, until the annealing time was increased to at least 60 seconds. However, by increasing the annealing time, the consequent dopant redistribution approaches .1 µm, which redistribution is near the limit of acceptability for MOS-VLSI device, but too large for the very high speed bipolar devices.

Therefore, it would be highly desirable to have a processing system and method for overcoming the excessively diffusive redistribution problem associated with high dosage dopant implanted semiconductor devices. Such a processing system and method should achieve uniformity of activation of implanted dopants over large wafers with minimal, or at least greatly reduced, diffusive redistribution.

Another attempted solution which has also proven to be less than satisfactory, is the use of an isothermal annealer. In this method, infrared radiation from a resistance heat sheet of graphite is used to heat the wafer to be annealed. This technique resulted in production of semiconductor devices comparable to those obtained by employing furnace annealing equipment, but has not proven at all satisfactory for the smaller high dopant semiconductor devices.

Yet another attempted solution to the concerns associated with the prior art, included the use of a laser to scan and to heat the semiconductor wafer rapidly. This method has also proven to be less than satisfactory, since it was discovered that in order to achieve uniform activation of the dopant over the entire semiconductor material surface, the laser scan lines were required to be overlapped. It was also found, however, that if the scan lines are heavily overlapped, microfractures are produced which act as strong sources for dislocation generation, thereby rendering the device defective. In this regard, undesirable non-uniform annealing of the semiconductor substrates occurs, since certain areas of the substrates receive a relatively excessive flux of energy. Moreover, the cost of such lasers required to achieve the necessary rapid heating, has proven to be a relatively expensive and complex process, and otherwise less than satisfactory. In this regard, trained and skilled personnel are required to operate the expensive laser equipment.

In general, the use of a coherent light beam, such as a conventional laser beam, is subject to diffraction, which further reduces the performance of the annealing process because of the nonuniformities in the diffraction pattern. Additionally, an overly extended exposure to the laser beam can cause micro-cracks or micro-crystalline damage to the substrate. Thus, the prior known laser annealing processes do not produce entirely satisfactory results for some applications. In this regard, the resulting products are oftentimes defective, and an undesirably high reject rate does occur all too frequently. Thus, known processes frequently produce unwanted side affects, are relatively time consuming, and are costly due to the large number of rejects.

Therefore, there is a need for an annealing process and equipment which prevent, or at least greatly eliminate the unwanted side affects. Such a new annealing technique should be relatively efficient and expedient.

As one type of laser proposed for annealing semiconductors, is the excimer laser. However, such a prior known excimer laser system, as hereinafter described in greater detail, has only been proposed, and has not been employed to any great extent in the actual production of semiconductors. In this regard, such systems have not been entirely practical, because of their inherent low efficiency, and low throughput. Thus, the cost to operate such a system is prohibitively high. Additionally, the cost of manufacturing such a system is also prohibitively high, and therefore uneconomical to both construct and to use in modern mass production technology. Also, the previously mentioned problems associated with laser annealing techniques apply to the excimer laser annealing techniques. For example, the problem of diffraction is equally applicable to an excimer laser technique.

Therefore, it would be highly desirable to have a system and method for achieving the uniform activation of implanted dopants in a rapid manner, without damaging the semiconductor wafer being annealed. Such a system and method should be able to be implemented at a relative low cost.

In the manufacture of certain products, maintaining a clean surface treating area is extremely important. In this regard, highly intense ultraviolet light has been used in cleaning vehicle surfaces, particularly of toxic chemical warfare agents.

While prior known vehicle surface cleaning techniques have been successful for some applications, it has been difficult, if not impossible, to employ conventional cleaning techniques for refinishing the surface of large air and sea vehicles, such as certain aircraft, ships, or the like, without moving the vehicle to a special processing area, due to various pollutants created during the refinishing process. The pollutants include not only air borne particles and debris which are removed from the surface of the vehicle being treated, but also includes water or sand being discharged forcefully against the surface being cleaned and organic (chlorinated hydrocarbon) solvents used in stripping epoxy and polyurethane paints. Such pollution is, or course, undesirable and unwanted, and is prohibited by laws or regulations in certain situations. Thus, when a vehicle requires refinishing, it is desirable to enclose the vehicle in a special processing shed or hanger to avoid contaminating the general environment with the pollutants formed by the dislodged coating materials and substances.

Therefore it would be highly desirable to have a new and improved system which enables a vehicle to be stripped of unwanted and undesired coating materials and substances, without using high velocity jet-streams which would otherwise produce air borne particles or other pollutants as the coating materials being removed from the surface of the vehicle.

In other surface treating applications, such as in the manufacture of metallic parts, there are various steps involved in processing the surface of such parts. One such step, relates to glazing the surface of the metallic part to give it a hardened, durable finish. While the prior known techniques employed to accomplish such a processing step have been acceptable for some applications, they have not been entirely satisfactory.

One attempted solution to the conventional metal glazing techniques was to use a laser to scan and to heat the surface of the material. While this technique tends to localize heating, it has proven to be less than entirely satisfactory in certain applications to provide the desired durability. Moreover, the cost of the lasers required to achieve the necessary rapid heating for glazing purposes, has proven to be a relatively expensive, and the glazing technique is unduly complex. In this regard, trained and skilled personnel are required to operate the expensive laser equipment.

Metal glazing is employed for certain intricate parts that having holes, apertures, and recesses. For example, in the manufacture of engine blocks, it is very desirable to glaze the cylinder walls of the block to improve the durability of the wear surfaces.

Thus, there are a variety of different types and kinds of surfaces requiring improved forms of treatments. Thus, it would be highly desirable to achieve such improved forms of treatment through the use of high intensity ultraviolet light.

There have been some plasma systems which have produced highly intense ultraviolet light, but such systems were merely incidental to some other application. For example, Lochte-Holtgreven (see Atom hern energie 28(1976), pages 150-154) reported the use of exploding liquid threads in studying nuclear fusion reactions. When extremely high voltage is present across a concentrated solution of lithium in heavy ammonia, forming the liquid thread, a violent explosion caused a neutron burst to occur. Assuming that pycnothermal nuclear reactions occur coincident to the neutron burst, this method could be employed to study nuclear fusion. While the explosion causes a dense plasma to exist, the plasma recoiled in an unstable manner, totally unacceptable for the desired production of a highly intense and uniform ultraviolet light.

Additionally, in U.S. patent 4 635 282, thee is a disclosed gas injection type plasma X-ray source, with high X-ray conversion efficiency, for use in X-ray lithography methods. A fine pattern of soft X-rays are used in the fabrication of semiconductor integrated circuits. However, the plasma is not at all suitable for use in the production of intense, uniform ultraviolet light.

U.S. patent 4 718 974 discloses a method and apparatus for removing organic polymers, such as photoresist, from the surface of an object, such as a semiconductor wafer. The technique employs a microwave energy source to induce the generation of high intensity, but noncoherent, far-UV light. The UV light effectively vaporizes the photoresist which is then removed from a reaction chamber by gas exchange. The UV light generated by this apparatus is not sufficient, nor is it intended, to anneal or etch a semiconductor wafer effectively.

### Disclosure of Invention

Therefore, the principal object of the present invention is to provide a new and improved system and method of treating material surfaces by utilizing high intensity ultraviolet light surfaces.

Another object of the present invention is to provide such a new and improved system and method for glazing material surfaces.

Another object of the present invention, is to provide such a new and improved system and method of stripping material surfaces of unwanted or undesired coatings and other substances.

Another principal object of the present invention is to provide a new and improved system and method of processing semiconductor material by the utilization of high intensity incoherent ultraviolet radiation.

Another object of the present invention is to provide a new and improved system and method for circuitizing semiconductor material.

Another object of the present invention is to provide such a new and improved system and method for activating implanted dopants uniformly in a semiconductor wafer in an improved manner.

Another object of the present invention, is to provide such a new and improved system and method of annealing a semiconductor wafer to reduce greatly dopant diffusive redistribution.

Yet another object of the present invention is to heat semiconductor material uniformly and rapidly without causing, or at least greatly reducing, destructive thermal stresses or implanted dopant therein.

The above and further objects and features of the present invention are realized by providing a method according to claim 1, an apparatus according to claim 5 and a process according to claim 14 and 19. The inventive apparatus and method may be utilized to strip or to clean material surfaces, of unwanted and undesired coatings. The inventive system and method may also be employed, to glaze metal and the like materials in an improved manner.

The inventive apparatus and process include exposing a material surface to an incoherent ultraviolet light source, which is controlled at a very high repetition rate. For example, when used to glaze the surface of a material, a high intensity ultraviolet light is guided toward the surface of the material to be glazed. The material is then exposed to the ultraviolet light which is pulsed at a very rapid rate, for a sufficient amount of time to cause the surface of the material to be glazed.

By employing the inventive apparatus and method, material surfaces can be readily treated in an improved manner. For example, a high intensity light system pulsed at a high repetition rate, irradiates the surface of the material to strip it of all coating materials in a highly effective and efficient manner. The ultraviolet radiation produced by the light source provides a desired shallow depth of penetration, while the high peak power causes the coating material to separate from its substrate or surface, without producing unwanted and undesired airborne particles to form pollution.

Thus, the novel apparatus and method of the present invention are utilized to treat surfaces in a vastly superior manner, and to produce finished products characterized by improved surface characteristics.

The above and further objects and features of the present invention are further realized by providing a new and improved system and technique for processing semiconductor material. In one form of the present invention, of the inventive method is employed, to anneal semiconductor material, such as a doped semiconductor wafer.

The inventive process includes exposing semiconductor material to an incoherent light source, which is controlled at a high repetition rate. When used to anneal semiconductor material, a high repetition rate ultraviolet light source is exposed to the material to be annealed at a rapid duration, such as about 10 microseconds less, and of a sufficient intensity to raise the surface temperature of the doped semiconductor material to a predetermined annealing temperature, such as about 800°C or greater.

By employing the inventive method, semiconductors can be readily processed in an improved manner. In one form of the invention, a high intensity pulsed light source at a high repetition rate, irradiates the surface of the semiconductor material to penetrate it in a highly effective and efficient manner. The ultraviolet radiation produced by the light source provides a desired shallow depth of penetration, the high peak power causes the material to undergo the desired transformation, and in the high pulse repetition rate fosters high material throughput. In this regard, by way of a mechanical analogy, a pneumatic jack hammer provides a surface breaking impact at a high repetition rate to cover the desired area. On the other hand, a similar jack hammer, even a more powerful one, that operates at a very slow rate of only one impact per hour, would not accomplish the desired result of completing the job in an effective and efficient manner.

### Brief Description of Drawings

The above mentioned and other objects and features of this invention and the manner of attaining them will become apparent, and the invention itself will be best understood by reference to the following description of the embodiment of the invention in conjunction with the drawings, wherein:
FIG. 1 is a pictorial diagrammatic view of a land vehicle mounted material treating ultraviolet light emitting system which is adapted for treating the surface of a large item of manufacture, and which is constructed in accordance with the present invention;
FIG. 1A is a diagrammatic view of a semiconductor processing system, which is prior art, and which is employed for annealing semiconductor materials;
FIG. 2 is an enlarged sectional view of the light emitting head or device of the system of FIG. 1;
FIG. 2A is a diagrammatic view of still another semiconductor processing system, which is also constructed in accordance with the present invention and, which is employed for circuitizing semiconductor materials;
FIG. 3 is a sectional view of the device FIG. 2 taken substantially on line 3-3 thereof;
FIG. 3A is an diagrammatic view of a further semiconductor processing system, which is similar to the system of FIG. 2, and which is constructed in accordance with the present invention for annealing semiconductor materials;
FIG. 4 is a diagrammatic sectional view of the on-board unit of the system of FIG. 1;
FIG. 4A is a diagrammatic view of still a further semiconductor processing system, which is also constructed in accordance with the present invention, and which is used for annealing semiconductor materials.
FIG. 5 is a diagrammatic, elevational view, partially in section, of another material processing system, which is constructed according to the present invention, and which is illustrated treating the interior surfaces of an aperture or hole;
FIG. 6 is a diagrammatic view of an overhead mounted material processing system, which is also constructed in accordance with the present invention, and which is illustrated in the process of treating a vehicle;
FIG. 7 is an enlarged, fragmentary partially diagrammatic sectional view of the material processing system of FIG. 6 taken substantially on line 7-7 thereof; and
FIG. 8 is a diagrammatic view of yet another material processing system which is also constructed according to the present invention, and which guides radiated ultraviolet light within a processing chamber.

### Best Mode for Carrying Out the Invention

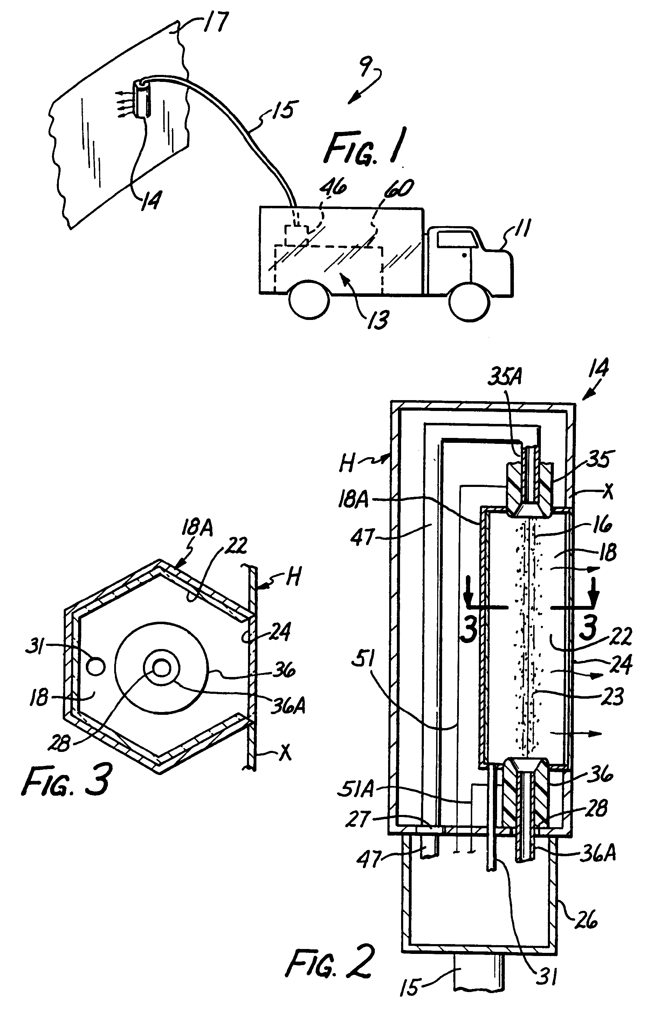

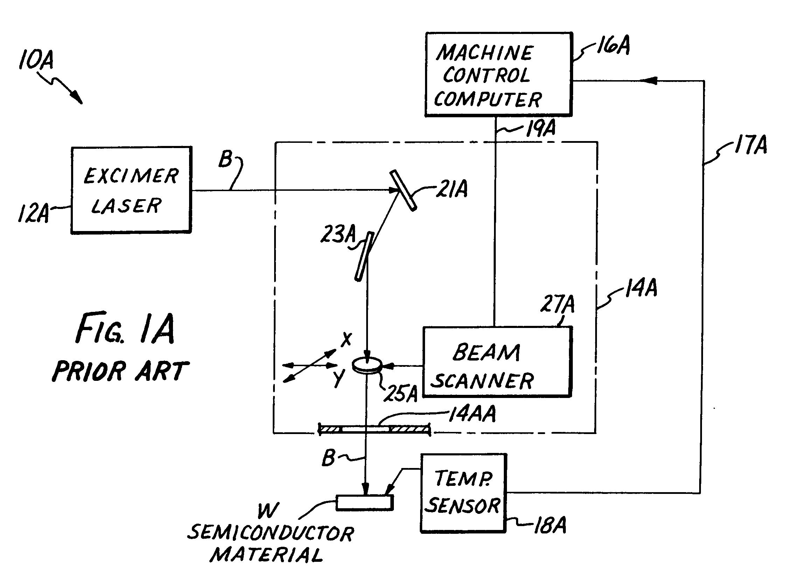

Referring now to FIG. 1 there is shown a liquid-jet plasma pinch surface treating system 9, which is constructed in accordance with the present invention, and which is adapted to be mounted on board of a mobile unit or vehicle 11 in the form of a vehicle such as a truck or van. In this regard, the mobile unit 11, is able to transport conveniently the liquid-jet surface treating system 9 so that it can be utilized in a variety of applications such as applications involving large, bulky surfaces to be treated. For example, the system 9 can be used to clean unwanted coating material from structures, including walls and other large surface areas. The system 9 can also be transported to an aircraft to strip its outer painted surface of its paints and the like, without polluting the air.

The liquid-jet plasma pinch surface treating system 9 generally includes an on-board plasma control assembly or unit 13 connected via a cable 15 to an ultraviolet light emitting head or assembly 14 for treating a surface 17. The liquid-jet plasma pinch system 14 establishes a source of high intensity incoherent ultraviolet light radiation of a sufficiently high intensity that it will remove by sublimation, evaporation, photodecomposition and spallation unwanted coating material covering the surface 17. The short wavelength ultraviolet light radiated from the head 14 of the system 9 as illustrated by wavy lines, penetrates the surface 17 to be treated, only to a very shallow depth, generally in the range of .1µm or less. Accordingly, the radiated ultraviolet light will separate surface coatings (not shown) from its underlying substrates, without substantially affecting the underlying surface 17.

Considering now the process of treating the surface 17, to remove a coating of material therefrom, a user (not shown) drives the mobile unit 11 to a location near the surface 17. The user then manually or by means (not shown) positions the liquid-jet plasma pinch head 14 adjacent to the surface 17 to be stripped and activates the plasma control system 13. When the plasma control system 13 is activated the liquid jet plasma pinch head 14 emits pulsed high intensity incoherent ultraviolet light which the user directs and guides along the surface of the object to be treated.

As the ultraviolet light bathes the surface 17 of the object, the surface is rapidly heated to cause the coating material to be separated from its substrate, and otherwise removed or discharged therefrom.

Once the system 14 has been transported to the surface to be treated by the mobile unit 11, a user of the system 9 can move the liquid-jet plasma pitch light emitting head 14 manually or by means (not shown) relative to the surface 17 to be treated. It should be understood that the surface 17 may form a part of a larger structure, such as an aircraft, building or any other such large object requiring surface treatment. In this manner, the entire surface area of an item, such as an aircraft (not shown), may be treated with the high intensity incoherent ultraviolet light radiated by the liquid-jet plasma pinch system 9.

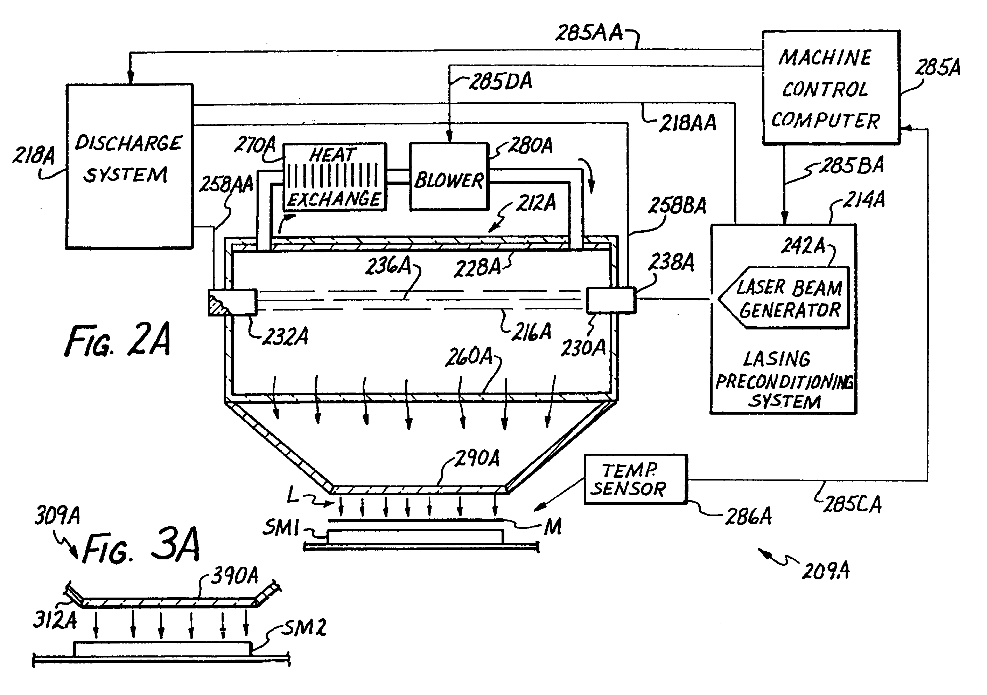

Considering now the liquid-jet plasma pinch system 9 in greater detail with reference to FIGS. 1-4, the plasma control assembly or unit 13 is used with the plasma source liquid-jet pinch device or apparatus 14 to establish a central narrow liquid channel which is generally illustrated in broken lines at 16 (FIG. 2), for supplying mass for a plasma to be formed and pinched thereamong as more completely described in greater detail in EP-A-89901826.1 (= WO 89/05515). The unit 13 includes a housing H, which has an inner elongated housing 18A having an evacuated sealed chamber 18, in which the liquid jet plasma pinch is established to produce the ultraviolet light. The liquid channel 16 extends axially within the chamber 18, and is initially in the form of a stream of liquid which flows under pressure through the chamber 18. A liquid vapor cloud 23 surrounds the liquid stream as it passes through the interior of the chamber 18, and cooperates therewith to form the main preionizing driver of the plasma system 12.

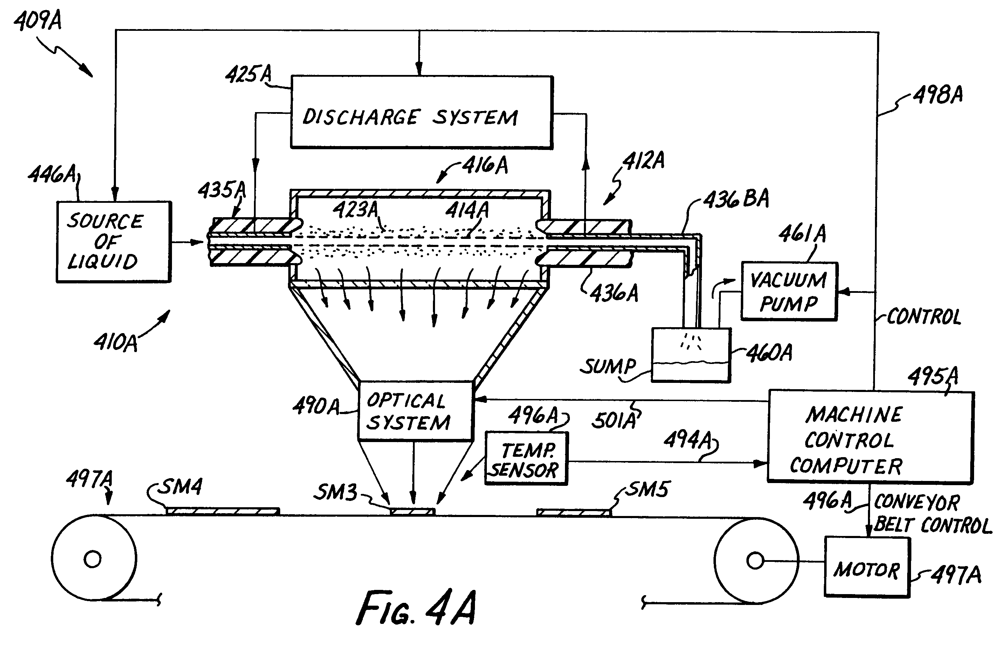

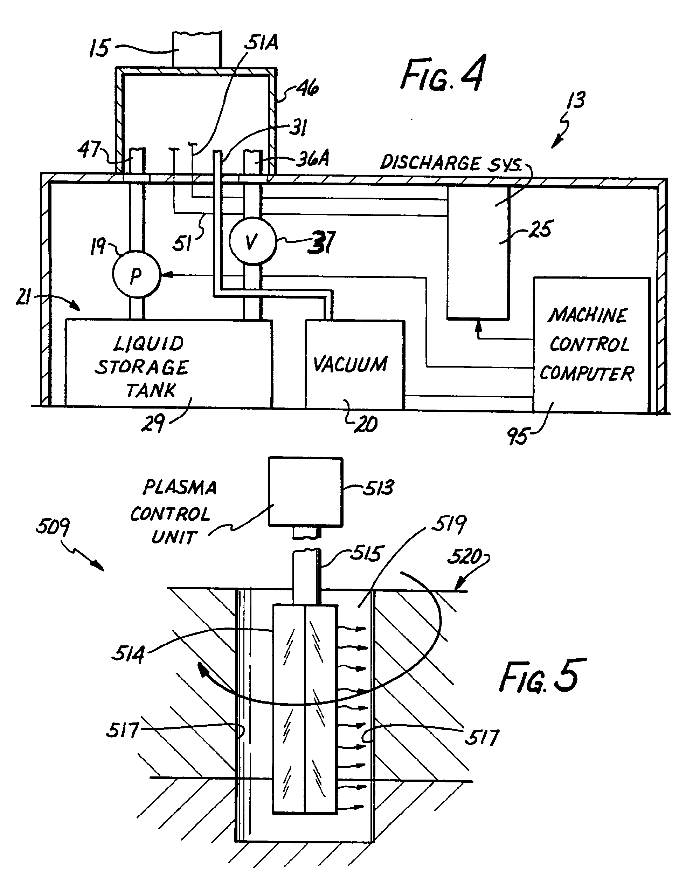

The plasma control assembly 13 includes a pump 19 (FIG. 4) for maintaining the flow of liquid via the cable 15 through the chamber 18. As shown in FIG. 4, the plasma control assembly 13 also includes a vacuum pump 20, which is connected in fluid communication via a suction or vacuum line 31 extending between the unit 13 and the head 14 via the cable 15, and for maintaining the chamber 18 evacuated. As best seen in FIG. 4, the plasma control system 13 also includes a liquid storage tank 21 which provides a source of liquid or fluid for the liquid-jet pinch head 14. A machine control computer 95 controls the operation of the plasma control system 13 and establishes the pulsing rate for an electrical discharge system 25 to cause the vapor cloud 23 to be ionized for producing the incoherent ultraviolet light emitted from liquid jet plasma head 14 as it traverses adjacent to the surface 17 to be treated. The discharge system 25 generates vapor ionizing high voltage pulses at a desired frequency, such as a frequency of between substantially one per second and substantially 1000 times per second, depending on the desired effect of the treatment. A more preferred range is between about 10 pulses per second and about 100 pulses per second. The most preferred repetition rate is about 100 pulses per second.

Considering now the head 14 in greater detail with reference to FIG. 2, a pair of axially spaced apart emitter and collector electrode assemblies 35 and 36 disposed at the opposite ends of the chamber 18 facilitate the establishment and maintenance of the liquid stream therebetween and a pair of electrical conductors 51 and 51A extend through the cable 15, and are connected electrically between the discharge system 25 and the electrical assemblies 35 and 36, respectively, for establishing an electrical current flow through the preconditioning vapor cloud 23 of liquid along channel 16 to establish the plasma. The electrode assemblies 35 and 36 contain a liquid emitter 35A and a liquid receptor 36A respectively for directing the stream of liquid axially through the chamber 18.

The discharge system 25 delivers the high voltage pulses across the assemblies 35 and 36, at a potential of approximately 30,000 volts, to cause an electrical current to flow initially through the vapor cloud 23 for plasma producing ionization purposes. The stream of liquid absorbs the energy emanating from the non-dense plasma or ionized vapor cloud 23, and is, in turn, heated thereby. The liquid stream then becomes ionized, and is transformed into a high-Z dense plasma pinch to provide the high intensity ultraviolet light.

The generated plasma then conducts the continuing discharge electrical current, and produces high-intensity ultraviolet light. The generated dense pinched plasma diverts most of the discharge electrical current from the surrounding non-dense plasma, and conducts it along the channel 16 through the chamber 18. The resulting plasma is substantially stable, and substantially uniform in cross section throughout its length.

Considering now the liquid jet chamber housing 18 in greater detail, it is generally an elongated vacuum chamber, which is polygonal in cross section throughout its axial length. In this regard, it is preferably generally hexagonal in cross section shape. A set of five reflective mirrors, such as a mirror 22, helps reflect or guide the incoherent ultraviolet light emitted from the high density plasma pinch through a transparent chamber window wall 24 forming a sixth wall through which the ultraviolet light is emitted toward the surface 17. The window wall 24 fits in, and is sealed over, by sealing means (no shown, an opening (not shown) in the wall "X" of the housing H. The transparent wall 24 is composed of material such as quartz, which is transparent to ultraviolet light.

The liquid jet head 14 includes housing extension 26 having a pair of connectors 27 and 28 that permit fluid communication between the liquid storage system 21 and the electrode assemblies 35 and 36 inside the chamber 18. Connector 27 is an inlet connector for permitting liquid to flow under pressure via a conduit or tube 47 into the chamber 18, while connector 28 is an outlet connector for permitting liquid to flow from the chamber 18 back via a conduit or tube 36A into the liquid storage tank 29 located in mobile unit 11, the tubes 47 and 36A extending through the cable 15.

Considering now the unit 13 in greater detail with reference to FIG. 4, the unit 13 includes a small extension housing 46 which is substantially similar to the corresponding extension housing 26, and which connects the end of the cable 15 to the unit 13. A control valve 37 disposed within the housing 60 controls the flow of liquid into the liquid storage tank 29.

As best seen in FIG. 4, housing 60 confines the liquid storage tank 19, the vacuum pump 20, the discharge system 25, the machine control computer 95, and a portable power system (not shown) for supplying electrical power to the plasma control unit 13. It should be understood that the base housing unit 60 may include a set of rollers (not shown) so that it may be easily loaded onto and off of the mobile unit 11. In this manner, the entire system 9 can be transported by the mobile unit 11 to a remote location, and if desired, off loaded and moved to a locale not otherwise accessible to the mobile unit 11.

Referring now to FIG. 5, there is illustrated an ultraviolet light surface treating system 509, which is also constructed in accordance with the present invention, and which is adapted for use in an inventive parts manufacturing process for treating the surface of a workpiece or object in the form of an engine block 520 having a cylinder bore 519 to be glazed. The illustrated and described system 509 is able to perform a variety of surface treating processes, such as biological decontamination, chemical decontamination, ceramic glazing, metal glazing, plastic film removal, metal film removal, and the like. It should therefore be understood that, although only a glazing process will hereinafter be described, the other mentioned processes, are performed in a similar substantially the same manner, with only the exposure time being varied to accomplish the intended purpose.

The surface treating system 509 is similar to the liquid-jet plasma pinch system 9, except that the system 509 is adapted to treat inside surfaces, even on small parts. In this regard, the system 509 includes a plasma source system 513 having a plasma pinch head 514, which emits a highly intense ultraviolet light, and which is adapted to be lowered into an opening, such as the bore 519.

The ultraviolet light emitted from the plasma pinch head 514 is directed toward the interior surface of an object, such as the engine block cylinder 520. The engine block 520 and the head 514 are manually rotated relative to one another or by motive means (not shown) about the axis of the bore 519 so the entire interior wall surface of the cylinder bore 519 is exposed to the ultraviolet light emitted from the head 514, for glazing purposes. The plasma control unit 513, which is substantially identical to the plasma control assembly 13 of FIG. 1 flexible cable 515 which is similar to the cable 15 of FIG. 1, couples the plasma pinch head 514 to the control unit 513.

Considering now the process of treating an interior surface, such as the surface 517 of the bore 519, for glazing purposes, a conveyor system (not shown) positions the engine block 520 in the general proximity of the plasma pinch head 514. The plasma pinch head 514 is then manually positioned by means (not shown), entirely within the bore 519 adjacent to the surface 517 to be glazed. When the head 514 has been so positioned, the plasma control assembly 513 is activated to cause the head 514 to emit high intensity incoherent ultraviolet light, which is directed radially against a portion of the cylindrical wall surface 517 to be glazed. The block 520 is then rotated manually or by means (not shown) about the axis of the device 514. Alternatively, the head can be rotated, and the block remains stationary.

As the block 520 and the head 514 are rotated about the axis of the head 514 relative to one another, the interior wall surface 517 of the block 520 is rapidly heated to cause the surface to be glazed.

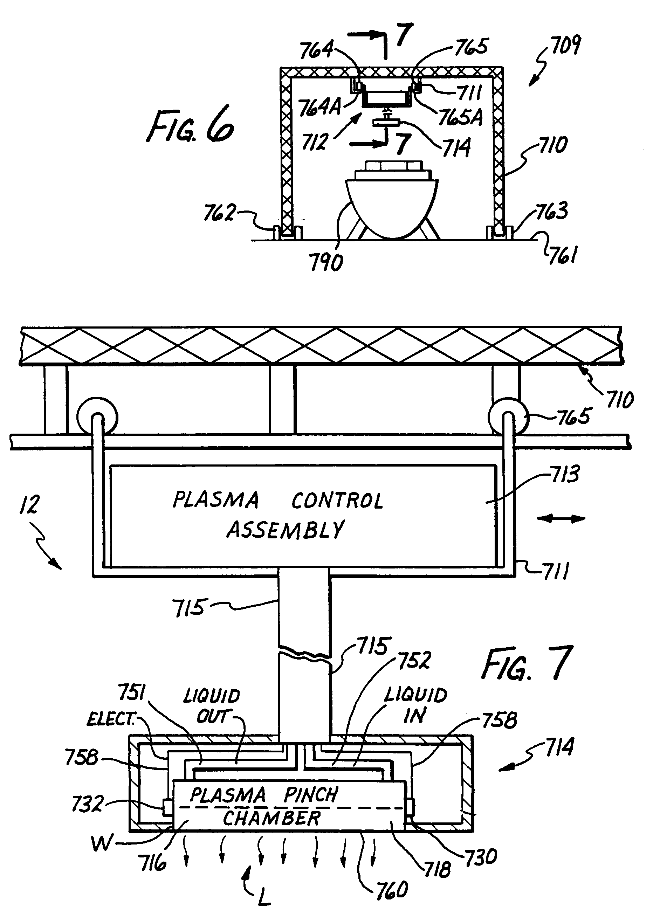

Referring now to FIGS. 6 and 7, there is illustrated a plasma pinch treating arrangement 709, having a liquid jet plasma pinch system 712, which is also constructed in accordance with the present invention, and which is adapted for use with a movable crane 710 to treat the exterior surface of a large stationary object, such as a ship 790. In this regard, the crane 710, is rollably supported on the ground 761 by wheels 762 and 763, and is able to transport the plasma pinch system 712 along the longitudinal axis of the ship 790 so that the entire exterior surface areas side of along either its longitudinal axis may be treated.

The crane 710 supports from above a movable platform 711 for carrying the system 712 rollably on wheels such as wheels 764 and 765 aloud overhead tracks 764A and 765A of the crane 710, and for permitting the system 712 to be moved along the horizontal axis of the ship.

The liquid jet plasma pinch system 712 is similar to the system 10 of FIG. 1 and establishes a source of high intensity incoherent ultraviolet light radiation of sufficient intensity to remove unwanted or undesired coating materials covering a surface of an object, such as the ship 790. The high intensity, pulsed ultraviolet light radiated by the system 712 as indicated illustrated by wavy lines generally designated at L, penetrate the surface of the object to be treated to a very shallow depth only. Accordingly, the radiated ultraviolet light removes surface coating without substantially affecting the object to which the coating is affixed.

The plasma pinch system 712 includes a plasma control assembly 713 which is mounted on the movable platform 711, and which is similar to the plasma control assembly of FIG. 1. The platform 711 is movable manually or by motive means (not shown). The system 712 also includes a liquid jet plasma pinch assembly or head 714 which is connected to the plasma control assembly 713 by a flexible cable 715, and which is similar to the head 14 of FIG. 1. The head 714 is also movable manually or by motive means (not shown) relative to the surface to be treated. In this manner, the entire surface area of a large object such as the ship 790, may be accomplished simply and conveniently. For a more complete explanation of the liquid jet plasma pinch system 712, reference can be made to EP-A-89901826.1 (= WO 89/05515).

Once the system 712 has been positioned relative to the object to be treated, a user of the system may move the plasma pinch head 714 along the surface area of the object, to dislodge the unwanted and undesired coating materials.

Considering now the plasma pinch head 714 in greater detail with reference to FIG. 7, the head 714 generates a pulsed high intensity incoherent ultraviolet light, used to strip a coating from the surface of an object, such as the ship 790. The plasma is initiated within a liquid jet plasma pinch vacuum chamber assembly 718, which is similar to the chamber 18 of FIG. 1. As shown in FIG. 7, a liquid jet is directed along the chamber axis as indicated in broken lines at 716, so as to form a plasma pinch in the region along the liquid jet, in a manner as previously for the head 14 of FIG. 2.

Considering now the plasma control assembly 713 in greater detail with reference to FIG. 7, the plasma control assembly 713 is connected via the depending flexible cable 715 to the head 714, and is similar to the control assembly 60 of FIG. 4.

A pair of liquid conduits 751 and 752 conveying the plasma forming liquid under pressure into and out of the chamber 718.

The discharge system (not shown) in the assembly 713 is connected via electrically leads 758 for generating high voltage electrical pulses to establish a plasma pinch along the liquid stream 716 thereamong. A pair of electrodes 730 and 732 are connected to the respective lines 758 and 758 for delivering plasma ionizing current along the liquid stream 716 between the electrodes 730 and 732. Thus, ultraviolet radiation L is emitted substantially uniformly over the duration of the pinch and is radiated through a window W.

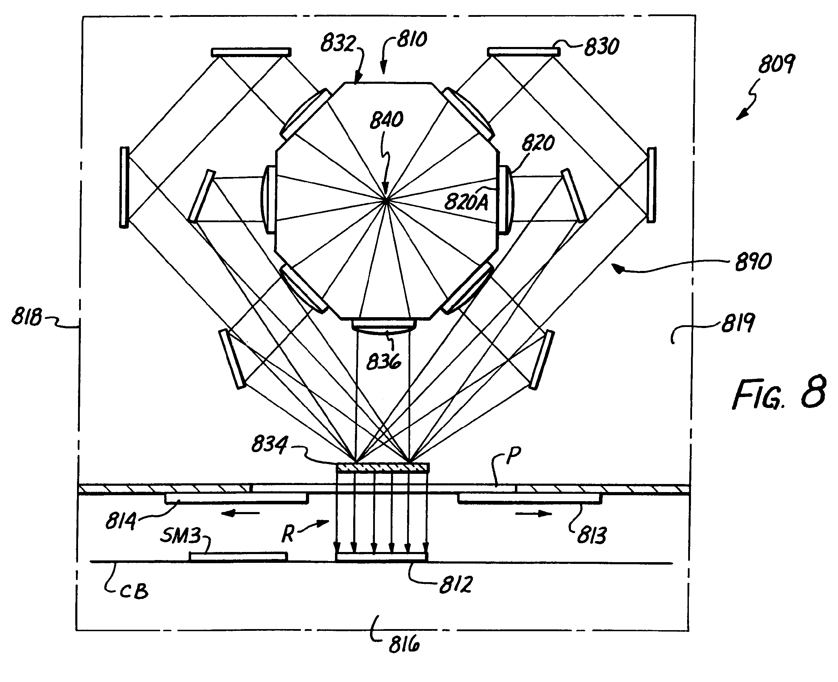

Referring now to FIG. 8, there is illustrated a semiconductor processing system 809, which is also constructed in accordance with the present invention; and which is adapted for use in a step of a semiconductor manufacturing process. The step of the process could be at an anneal, etching, super cleaning, or the like surface treatment of semiconductor materials, such as the semiconductor materials SM3, or 812 on a conveyor belt CB. The illustrated and described system 809 is a surface treating system, which is similar to the liquid jet plasma pinch surface treating system 9 described herein. While the system 809 is able to perform a variety of surface treating processes, such as super-cleaning semiconductor materials, annealing or etching of various components, chemical synthesis, and the like, a super-cleaning process will be described hereinafter in greater detail. However, it should be understood that the other mentioned processes are performed on substantially the same manner, with only the exposure time of the surface being varied to accomplish the intended process.

As the illustrated and described system 809 is substantially similar to the liquid-jet plasma-pinch surface treating system 9 previously described, only those aspects of the system which are of significant difference will be described hereinafter in greater detail. It should be understood however, that the system 809 emits a highly intense pulsed ultraviolet light, which is directed toward the surface of an object, such as object 812 via an optical system generally indicated at 890. The optical system 890 permits a large amount of the incoherent radiated ultraviolet light to bathe the object 812 with a pulse highly intense ultraviolet light in an efficient manner, because of the light collecting and directing capabilities provided by the optical system 809.

Considering now the system 809 in greater detail with reference to FIG. 8, the system 809 utilizes a liquid-jet plasma-pinch system generally indicated at 810 for establishing a source of high intensity ultraviolet radiation indicated by the solid parallel lines indicated at R.

The pinched plasma generates an ultraviolet light of sufficient intensity to super-clean the semiconductor material, such as material 812 or the material SM3, as they are being transported adjacent the optical lens system 890. As indicated diagrammatically in FIG. 8, the optical system 890 permits the radiated ultraviolet light to be reflected over the entire surface of the material.

The liquid-jet plasma-pinch system 810 includes an enclosed processing chamber indicated at 818 for confining the liquid-jet plasma pinch 810 and the optical system 890. The processing chamber is in atmospheric communication with a source of inert gas, such as helium, which back-fills the chamber 818. The purpose of the inert gas is to help facilitate the passage of the emitted ultraviolet light in a generally unimpeded manner, known to those skilled in the art, that air or other non-inert gases react with and absorb the ultraviolet light thereby diminishing its life duration.

As best seen in FIG. 8, the system 810 also includes a housing 818 defining a chamber with an outlet window or port, over which a pair of exposure doors 813 and 814 are movably manually, or by motive means (not shown) to be moved between a normally closed position over port P, and a fully opened position to expose the object or workpiece to the intense ultraviolet light emitted from the pinch system 810. Exposure doors 813 and 814 block the ultraviolet light emitted from the plasma pinch 840 from being exposed to a working area 816, until the next object, such as the semiconductor material SM3, is moved by the conveyor belt CB to the area 816 opposite the port.

The liquid-jet plasma-pinch system 810 includes a plasma control assembly (not shown), which is substantially similar to plasma control assembly 13, and thus, will not be described hereinafter in greater detail.

Considering now the doors 813 and 814, they are slidable mounted in a common vertical plane, and move toward and away from one another. When closed, they engage one another in a side-by-side configuration. When fully opened, they are spaced apart fully out of alignment with the port P.

Considering now the optical system 890 in greater detail with reference to FIG. 8, the optical system 890 generally includes a plurality of lenses, such as a spherical quartz lens 820, which individually fit within windows, such as a window 820A for the lens 820, of a plasma chamber shown diagrammatically at 832, within the larger chamber 819. The optical system 890 further includes a plurality of mirrors, such as mirror 830 disposed within chamber 819, outside chamber 832. The lenses, focuses the high intensity incoherent ultraviolet light emitted radially from the plasma pinch, shown diagrammatically at 840 toward the mirrors, such as mirror 830 and from the mirrors forwardly to a common lens at the port P. As the ultraviolet light impinges upon the reflective surface of the mirrors, the mirrors are so arranged to reflect light either directly or indirectly forwardly through the common lens 834 within the chamber 819, toward a single object surface such as the surface of the semiconductor material 812. In this manner, in order to utilize more efficiently and effectively the light generated by the pinch 840, a substantial portion of the high intensity incoherent ultraviolet light emitted from the plasma pinch 840 can be collected and directed toward the surface of the material to be treated.

The lenses are arranged surrounding the plasma pinch 840 to focus the incoherent light from the pinch 840 radially outwardly from the inner plasma chamber 832. For each one of the lenses, except the forward or front lens 836 which focuses directly at the common lens 834, there is a corresponding mirror which reflects the light passing through the lens either directly to the common lens 834, or to another one of the mirrors and then to the common lens 834.

Considering now the super or ultra cleaning process in greater detail with reference to FIG. 8, for the purpose of super-cleaning the surface of a semiconductor wafer, such as semiconductor material SM3, the conveyor belt CB moves the material SM3 into the working area or exposure chamber 816 of the housing 818. When the material SM3 is so positioned relative to the port P, the exposure doors 813 and 814 are moved manually or by motive means to their fully opened position, thereby permitting the material to be exposed to the ultraviolet light being focused within the working area 816 by the optical system 890. As the material is bathed in the ultraviolet light via the optical system, a temperature sensing or optical scattering device (not shown) monitors the condition of the semiconductor material 812 so that the surface temperature will not be raised to an excess temperature that might either damage or modify the conductivity properties of the semiconductor material SM3.

When the material has been raised to a sufficient temperature for super cleaning the surface thereof, the exposure door 813 is moved to a closed position to retain the helium therewithin, and the semiconductor material SM3 is carried via the conveyor belt CB out of the chamber. This process is repeated for each workpiece or material to be processed. It should be understood by the working area 816 being disposed within the chamber 818, working area 816 is also back filled with the inert helium gas to assure that a substantial portion of ultraviolet light generated by the plasma pinch 840 is able to be utilized in processing the semiconductor material SM3. As an alternative technique, the door can remain opened for a predetermined time interval so that the workpiece or object is exposed to the ultraviolet light for a predetermined time interval.

The liquid-jet plasma-pinch system 810 may be mounted in a mobile unit (not shown) or in a fixed processing location, such as a processing center (not shown). In this regard, the system 809 may be transported to a remote location to process a single work piece object or conversely, the system 809 may be set up in a manufacturing facility to process a multiple number of work piece objects on an assembly line basis.

While particular embodiments of the present invention have been disclosed, it is to be understood that various different modifications are possible and are contemplated. For example, there are a variety of different types and kinds of applications for the system and method of the present invention. In this regard, references may be made to the following table:

### APPLICATIONS

SEMICONDUCTOR ANNEALING
METAL GLAZING (met-glass anti-wear, anti-corrosion surface)
CHEMICAL DECONTAMINATION OF SURFACES
BIOLOGICAL DECONTAMINATION OF SURFACES
AIRCRAFT PAINT STRIPPING (composites and honeycombs)
ULTRA-CLEAN SURFACES (electronics and optics fabrication)
CLEAN SURFACES (coated metals production)
CORROSION REMOVAL (ferrous and non-ferrous metals)
CERAMIC GLAZING
MATERIALS TESTING (ultrasonic coupling)
CHEMICAL SYNTHESIS (photochemical catalysis)
PLASTIC FILM REMOVAL (plastics plant maintenance)
GRAFFITI REMOVAL (buildings and subway cars)
VARNISH REMOVAL (art restoration)
MARKING (electronic components)
PRINTING RUN CORRECTIONS (ink eraser)

Referring now to FIG. 1A, there is illustrated a semiconductor processing system 10A, which is prior art, and which is adapted for use in a semiconductor manufacturing process, for annealing semiconductor material, such as the material W. Before considering the inventive semiconductor processing system, it is well to review the prior art system 10A to better understand the short comings of the prior known techniques. The system 10A is described briefly, as being illustrative of prior known excimer laser annealing techniques.

The system 10A includes an excimer laser 12A, which emits a laser beam B directed toward the semiconductor material W and rapidly scanned across the surface thereof. The scanning rate of the laser beam B, as it traverses across the surface of the semiconductor material, is controlled so that the heat generated by the beam, causes the uniform activation of a dopant (not shown) implanted therewithin for annealing purposes.

Considering now the system 10A in greater detail with reference to FIG. 1A, the excimer laser device 12A is conventional and may be a laser, such as the one marketed by Cymer Laser, Inc. of San Diego, California, for generating the laser beam, which is generally illustrated as a line designated as B. The laser beam B is directed by the excimer laser 12A toward a laser beam scanning system generally indicated at 14A, which redirects the laser beam directly transversely toward the surface of the semiconductor material W for annealing it.

The excimer laser system 10A includes a machine control computer 16A, such as the one marketed by Allen Bradley Company, to control the operation of the system 10A. A temperature sensor 18A supplies a signal indicative of the temperature of the surface of the material W being annealed, via a lead 17A. For the purpose of controlling the direction and the rate at which the laser beam B traverses across the surface of the semiconductor material W, a beam scanner 27A controlled by the computer 16A via a lead 19A carries a lens 25A to move the beam B scanningly.

In operation, the excimer laser 12A emits the laser beam B toward the laser beam scanning system 14A, under the control of the machine control computer 16A for directing the laser beam B scanningly across the surface of the semiconductor material W in a predetermined X-Y pattern to cover it uniformly. As the laser beam B traverses across the surface of the semiconductor material, the surface of the semiconductor material is annealed by heating it in a very rapid manner.

For the purpose of optimizing the annealing of the surface of the semiconductor material W, the temperature sensor 18A, such as an infrared temperature sensor, sends a surface temperature indicative signal to the machine control computer 16A, to monitor the process. Upon receipt of this signal, the machine control computer 16A modulates the laser power or scan rate to maintain optimum processing. In this regard, the beam B causes the temperature of the material W to rise in a rapid manner to the predetermined annealing temperature and the sensor causes the computer to control the process parameters for optimum performance.

Considering now the laser beam scanning system 14A in greater detail with reference to FIG. 1A, the machine control computer 16A is programmed to cause the laser beam scanning system 14A to direct the laser beam B, generated by the excimer laser device 12A, in a predetermined pattern toward the semiconductor material W through a window 14AA transparent to the beam B. It should, therefore, be understood that the machine control computer 16A is programmed in a conventional manner, to cause the laser beam B to be scanned at a controlled rate in a precise pattern and thus to cause the unwanted and undesirable overlapping of the beam scanning pattern, to achieve non-uniform dopant activation.

As best shown in FIG. 1A, the laser beam scanning system 14A includes a pair of mirrors, such as mirrors 21A and 23A which direct the laser beam B from the laser 12A toward the lens 25A interposed between the mirror 23A and the window 14AA, through which is directed the beam B onto the surface of the semiconductor material W. The beam scanner 27A is conventional, and may be a scanner manufactured by A & R Industries of Oceanside, California. The scanner 27A causes the lens 25A to deflect the laser beam B in a desired direction scanningly toward the surface of the semiconductor material. The beam scanner 27A is responsive to its control signal received from the computer via the lead 19A.

The excimer laser 12A, the computer 16A, and the beam scanner 27A are extremely expensive equipment. Furthermore, the excimer laser is highly inefficient, and the system 10A would have an unsatisfactorily low throughput in actual production processes.

Referring now to FIG. 2A, there is illustrated a semiconductor processing system 209A, which is adapted for use in a semiconductor manufacturing process for circuitizing the surface of semiconductor material, such as material SM1. The illustrated and described system is able to perform an etching process, employing a series of conventional etching masks, such as a mask M, having a desired circuit configuration (not shown) thereon and between the system 209A and the semiconductor material SM1. In operation, the system 209A emits light L which is directed toward the semiconductor material SM1 and the mask M interposed between the system 209A and individual ones of the semiconductor material SM1, for serving as a portion of a manufacturing process for semiconductor chips. As the light passing through the mask M impinges upon the surface of the semiconductor material SM1, the surface of the material becomes etched in a pattern determined by the mask M. The remaining portions of the etching process are conventional and are not described herein.

Considering now the system 209A in greater detail with reference to FIG. 2A, the system 209A generally utilizes a gas embedded plasma pinch to generate ultraviolet light L used to etch the material SM1. The plasma is initiated by lasing activity taking place within a vacuum chamber 212A containing a gas, such as Argon. The system 209A includes a lasing system 214A for establishing along a chamber axis 216A of the chamber 212A a plasma pinch by exciting gas within a limited volume of the chamber 212A. A discharge system 218A ionizes the gas along the chamber axis as indicated at 216A so as to form a plasma pinch in the region preconditioned by the laser beam.

A heat exchange unit 270A and a blower 280A cool and circulate the spent pinch gas of the system 209A as it is repetitively activated during the inventive process. The firings of the preconditioning and discharge system 214A and 218A are controlled by a machine control computer 285A via leads 285BA and 285AA respectively. An IR temperature sensing unit 286A detects the post-pulse residual temperature rise of the surface of the material SM1 being processed, and sends an electrical signal indicative of the processing performance to the computer 285A, via lead 285CA. The blower unit 280A is, in turn, controlled by the computer 285A via lead 285DA. In addition, whenever the temperature sensor 286A sends a signal to the computer 285A to indicate a predetermined temperature required for a given annealing process, the computer 285A can increase or decrease the intensity of the firings of the discharge system 218A in a precise manner. The lasing system 214A is well known and completely described in greater detail in U.S. patent 4,450,568.

In operation, gas is injected into the chamber 216A. Thereafter, the preconditioning system 214A via a low power laser beam generator 242A supplies a preconditioning beam which is transmitted into the chamber 212A through a preconditioning beam window 238A and along the chamber axis 236A. The preconditioning beam excites the gas particles in the vicinity of the chamber axis 236A, thus defining the preconditioned channel within which the plasma pinch is then formed.

The discharge system 218A is connected to the preconditioning system 214A via line 218AA to coordinate its actuation and for generating an intense electrical pulse along the chamber axis or channel 216A to establish a plasma pinch therealong. The discharge system is coupled to a pair of electrodes 230A and 232A via lines 258AA and 258BA for delivering current between the electrodes 230A and 232A. After being activated, the discharge system 218A delivers a stored charge between the electrodes 230A and 232A along the channel 216A inasmuch as it is composed of excited gas particles and thus conductive relative to the unexcited particles surrounding the channel. The current ionizes particles within the channel 216A to establish a plasma and to create a circumferential magnetic field. The magnetic field interacts with the current creating a centripetal force on the plasma tending to constrict or pinch the plasma toward and along the chamber axis 216A. Thus, vacuum ultraviolet radiation is emitted substantially uniformly over the duration of the pinch.

The vacuum ultraviolet radiation released by the pinch radiates throughout the chamber and is reflected by the mirror 228A and downwardly through a bottom transparent chamber wall 260A, and outwardly through the mask M, and from there, through a lens 290A and onto the top surface of the semiconductor material SM1 for etching purposes.

The machine control computer 285A controls and coordinates the operation of discharge system 218A, so that the system 209A may be repetitively activated at a very high rate of speed. In this regard, when the ultraviolet radiation released by the pinch is radiated onto the surface of the semiconductor material SM1, the temperature sensor 286A senses the post-pulse surface temperature rise of the semiconductor material. The temperature sensor 286A sends a signal to the machine control computer 285A indicative of the surface treatment level. The machine control computer 285A, in turn, responds to this signal and causes the system 209A to be repetitively activated at a predetermined rate, until the entire wafer has been covered. It is in this manner that the processing of the semiconductor material SM1 may be precisely controlled for the etching process.

Considering now the circuitizing process in greater detail with reference to FIG. 2A, as the ultraviolet radiation released by the plasma pinch is radiated through the lens 290A, the light is radiated on the mask M which includes a predetermined circuit pattern. The mask M, thus allows only certain portions of the ultraviolet radiation to reach the surface of the semiconductor material SM1. It is this portion of the radiated ultraviolet light which etches the surface of the semiconductor material.

The system 209A operates at a very fast repetition rate, in that it produces light pulses at a duration of about one millionth of a second. The repetition rate of the UV light pulses can be adjusted under the control of the computer 285A, between about 1 pulse per second, and about 1,000 pulses per second. A more preferred range is between about 10 pulses per second and about 100 pulses per second. The most preferred repetition rate is about 100 pulses per second.

Referring now to FIG. 3A, there is illustrated a semiconductor processing system 309A, which is constructed in accordance with the present invention; and which is adapted for use in an inventive semiconductor manufacturing process for annealing the surface of semiconductor material, such as semiconductor material SM2. The illustrated and described system 309A is an annealing system, which is similar to the semiconductor etching system 209A described herein.

The system 309A includes a lasing system (not shown) having a vacuum chamber 312A and an optical system 390A. The optical system 390A permits the radiated ultraviolet light to bathe the entire upper surface area of the semiconductor material SM2. The system 309A is similar to the system 209A, except for the absence of the etching mask M.

A single burst of the ultraviolet light causes the surface temperature of the semiconductor material SM2 to be raised. This rise in surface temperature is sensed by a temperature sensor (not shown), which sends a signal to a machine control computer (not shown) indicative of the surface temperature of the material SM2. The machine control computer in response to this signal causes the lasing system (not shown) to be repetitively fired, until the entire surface or set of wafers have been covered. Thereafter, the machine control computer terminates the firing operation so a new piece of semiconductor material may be processed in a similar manner.

Referring now to FIG. 4A there is illustrated a semiconductor processing system 409A, which is also constructed in accordance with the present invention; and which is adapted for use in an inventive semiconductor manufacturing process for annealing the surface of semiconductor material, such as material SM3. The illustrated and described system 409A is an annealing system, which is similar to the semiconductor etching system shown and described in EP-A-89901826.1 (= WO 89/05515). In this regard, the system 409A emits a highly intense ultraviolet light which is directed toward the semiconductor material SM3 via an optical system 490A. The optical system 490A permits the radiated ultraviolet light to bathe the semiconductor material SM3A.

Considering now the system 409A in greater detail with reference to FIG. 4A, the system 409A generally utilizes a liquid jet plasma pinch system 410A for establishing a source of high intensity ultraviolet radiation.

The liquid jet plasma pinch system 410A includes a plasma source liquid-jet pinch device or apparatus 412A, to establish a central narrow preconditioned liquid channel which is generally illustrated in broken line at 414A, for the plasma to be formed and pinched therealong, within a limited volume of a closed chamber 416A. The liquid channel 414A is initially in the form of a stream of liquid which flows under pressure through the chamber 416A maintained evacuated by means of a vacuum pump 461A.

A vapor cloud 423A surrounds the liquid stream, and cooperates therewith to form the main preionizing driver of the plasma system 410A. An electrical discharge system 425A is coupled to a pair of axially spaced apart electrode assemblies 435A and 436A at opposite ends of the chamber 416A, for directing the stream of liquid through the chamber 416A and for establishing an electrical current flow through the preconditioning vapor cloud 423A of liquid along channel 414A to establish the plasma.

A machine control computer 495A establishes the repetition rate at which the liquid jet plasma pinch system 410A is fired. This rate is the same as that described in connection with the system 209A. Also, the pulse width is the same as described in connection with the system 209A. The machine control computer 495A is coupled between a temperature sensor 496A via a lead 494A and the discharge system 425A via a lead 498A. The machine control computer 495A is also connected to a vacuum pump 461A for the purpose of controlling the evacuation of the vacuum chamber 416A after each firing.

For the purpose of injecting liquid into the chamber 416A for each firing, the computer 495A is also connected to a source of liquid 446A under pressure via the lead 498A. The machine control computer 495A is also connected to a motor 497A for driving a conveyor belt system shown generally at 497A. The conveyor belt system 497A transports the individual ones of the semiconductor material under the lens system 490A, to be irradiated by the ultraviolet light emitted therefrom.

In operation, a fine stream of liquid flows under pressure axially between the electrode assemblies 435A and 436A inside the chamber 416A. The discharge system 425A is thereafter activated for delivering a high voltage potential, such as approximately 30,000 volts, across the electrodes 435A and 436A, to cause an electrical current to flow initially through the vapor cloud 423A. The stream absorbs the energy emanating from the non-dense plasma or ionized vapor cloud 423A, and is, in turn, heated thereby. The liquid stream then becomes ionized, and is transformed into a high-Z dense plasma pinch.

The generated plasma then conducts the continuing discharge electrical current, and produces high-intensity ultraviolet light. The generated dense pinched plasma diverts most of the discharge electrical current from the surrounding non-dense plasma, and conducts it along the channel 414A through the chamber 416A. The resulting plasma is substantially stable, and is substantially uniform in cross section throughout its length. After each firing, the machine control computer activates the vacuum pump to maintain the vacuum and to permit the sump 460A to receive any excess liquid via a connection 436BA.

The pinched plasma generates an ultraviolet light of sufficient intensity to anneal the semiconductor material, such as materials SM3, SM4 and SM5 as they are transported under the lens system 490A. As best seen in FIG. 4A, the semiconductor material is of different sizes, and the optical system 490A permits the radiated ultraviolet light to be reflected over the entire surface of the material, regardless of its size. In this regard, the computer 495A can control the system 490A via a control lead 501A. The plasma becomes extinguished and then is re-established repeatedly by the activation of the device 425A under the control of the machine control computer 495A. In this regard, the foregoing steps of the process are repeated each time for re-establishing the plasma pinch in a recurring manner.

Considering now the annealing process in greater detail with reference to FIG. 4A, for the purpose of annealing the surface of the semiconductor material, such as the material SM3, in the form of a semiconductor wafer, the remote temperature sensing device 496A senses the surface temperature of the semiconductor material SM3. As it is heated by the radiated ultraviolet light, the remote temperature sensing unit 496A sends a signal to the machine control computer 495A to indicate that proper treatment has been achieved. The computer 495A, upon receipt of this signal, causes the repetitively pulsated ultraviolet light to be supplied to the wafer until a desired surface area is covered. Once the entire surface or set of wafers has been covered, the pulsing action is terminated under the control of the machine control computer 495A. Thus, the surface of the semiconductor material is processed to form a semiconductor device with a shallow junction having minimal dopant diffusion.

While particular embodiments of the present invention have been disclosed, it is to be understood that various different modifications are possible and are contemplated within the scope of the claims. There is no intention, therefore, of limitations to the exact abstract or disclosure herein presented.

## Claims

1. A method for treating a surface (17), comprising:
using a pair of spaced apart combination liquid emitter (35A) and electrode means (35), and combination liquid receptor (36A) and electrode means (36);
flowing between said pair of electrode means (35, 36) a fine stream of liquid (16) under sufficient pressure in a substantially narrow, straight and focused configuration, to cause the formation thereabout of a tenuous liquid vapor preconditioning cloud (23) surrounding the flowing fine stream of liquid;
establishing an electrical voltage potential difference between said electrode means of a sufficient high voltage to cause electrical current to flow through said liquid vapor cloud for establishing initially a low density plasma thereamong sufficient to emanate energy therefrom to said flowing liquid stream to heat it sufficiently to cause it to become ionized and to be converted into a high density plasma in response to said low density plasma;
using a plasma pinch assembly (14) coupled via a cable (15) to a plasma control assembly (13) wherein said combination liquid emitter and electrode means, and combination liquid receptor and electrode means are mounted within said plasma pinch assembly and coupled to said plasma control assembly;
moving said control assembly in proximity to the surface to be treated; and
moving said plasma pinch assembly relative to the surface to be treated to expose the surface to a high intensity incoherent ultraviolet light radiating from said high density plasma.

2. A method according to claim 1, wherein said treating is glazing, and the surface is one selected from the group consisting of metal and ceramics.

3. A method according to claim 1, wherein said treating is cleaning to dislodge substances from the surface.

4. A method according to claim 1, wherein said treating is marking the surface.

5. An apparatus for treating a surface (17) comprising:
a pair of spaced apart combination liquid emitter (35A) and electrode means (35), and combination liquid receptor (36A) and electrode means (36);
means for flowing between said pair of electrode means a fine stream of liquid (16) under sufficient pressure in a substantially narrow, straight and focused configuration, to cause the formation thereabout of a tenuous liquid vapor preconditioning cloud (23) surrounding the flowing fine stream of liquid;
discharge means for establishing an electrical voltage potential difference between said electrode means of a sufficient high voltage to cause electrical current to flow through said liquid vapor cloud for establishing initially a low density plasma thereamong sufficient to emanate energy therefrom to said flowing liquid stream to heat it sufficiently to cause it to become ionized and to be converted into a high density plasma in response to said low density plasma;
a plasma pinch assembly (14) for containing said high density plasma, said plasma pinch assembly including vacuum chamber means (18) for confining said plasma wherein said combination liquid emitter, and electrode means and combination liquid receptor and electrode means are mounted within said vacuum chamber means;
a plasma control assembly (13) for supplying the electrical voltage and the liquid to said plasma pinch assembly;
a flexible cable (15) for coupling said plasma control assembly to said plasma pinch assembly;
means for mounting movably said plasma pinch assembly relative to said plasma control assembly; and
means for mounting movably said plasma control assembly relative to the surface to be treated.

6. An apparatus according to claim 5, wherein said combination liquid emitter and electrode and combination liquid receptor and electrode means each comprise;
an inner tube composed of electrically conductive material to permit electric current to flow therethrough;
means connected in fluid communication with said inner tube for permitting liquid communication between the inner tube and the stream of liquid; and
an outer tubular element having nozzle means connected in fluid communication with said tube.

7. An apparatus according to claim 5, further comprising means for rotating said plasma pinch assembly (514).

8. An apparatus (809) for treating the surface of an object (812) according to claim 5 comprising:
plasma pinch means (810) for establishing a source of incoherent ultra violet light of sufficiently high intensity to treat the surface, including plasma chamber means (832) for confining said plasma;
optical means (890) for guiding said incoherent ultra violet light generated by said plasma pinch means (810) towards the surface to be treated;
means for exposing said object (812) to said incoherent ultra violet light from said optical means (890); and
gas-chamber means (818) for confining said plasma chamber means (832) and said object (812).

9. An apparatus according to claim 8, wherein said optical means includes a plurality of elements disposed surrounding said plasma pinch (840) to direct the light therefrom through an outlet port (P) in said gas-chamber means.

10. An apparatus according to claim 9, wherein said elements include lenses (820,834,836) and reflective members (830).

11. An apparatus according to claim 8, wherein said means for exposing said object (812) to said incoherent ultra-violet light includes means (813,814) for exposing said object (812) for a predetermined period of time.

12. An apparatus according to claim 8, wherein said gas chamber means (818) further confines said optical means (890).

13. An apparatus according to claim 8, wherein an inert gas is disposed within said gas chamber means (818).

14. A method of treating a surface of an object (812) with the apparatus according to claim 8 comprising:
using plasma pinch means (810) to establish a source of incoherent ultra-violet light;
using optical means to direct said incoherent ultra-violet light towards said object (812);
using means to expose said object (812) to said incoherent ultra-violet light from said optical means (890);
confining said plasma chamber means (832) and said object (812) in a gas chamber means (818).

15. A method according to claim 14, wherein using said means to expose said object (812) to said incoherent ultra-violet light includes moving said object (812) within said gas chamber means (818).

16. A method according to claim 14, wherein using said means to expose said object (812) to said incoherent ultra-violet light includes exposing said object (812) for a predetermined period of time.

17. A method according to claim 14, further comprising confining said optical means (890) within said gas-chamber means.

18. A method according to claim 14, further comprising disposing an inert gas within said gas chamber means (818) for helping to lessen the impedance to the passage of said incoherent ultra-violet light therethrough.

19. A process for treating the surface of a semiconductor material (812) to vary its conductivity properties, comprising:
using plasma pinch means for establishing an incoherent ultraviolet light of sufficient high intensity to cause the conductivity properties of substantially the entire planar surface of the semiconductor material to be varied uniformly, said establishing including using a pair of spaced apart combination liquid emitter (35A) and electrode means (35), and combination liquid receptor (36A) and electrode means (36); flowing between said pair of electrode means (35, 36) a fine stream of liquid under sufficient pressure in a substantially narrow, straight and focused configuration, to cause the formation thereabout of a tenuous liquid vapor preconditioning cloud (23) surrounding the flowing fine stream of liquid under pressure; establishing an electrical voltage potential difference between said electrode means (35, 36) of a sufficiently high voltage to cause electrical current to flow through said liquid vapor cloud (23) for establishing initially a low density plasma therealong sufficient to emanate energy therefrom to said flowing liquid stream to heat it sufficiently to cause it to become ionized and to be converted into a high density plasma in response to said low density plasma to generate high intensity incoherent ultraviolet light;
directing said ultraviolet light toward the entire surface of the semiconductor material (812) consisting of a semiconductor material having an implanted dopant for heating the entire surface thereof;
pulsating said ultraviolet light repetitively at a rate of at least once per second to cause the conductivity properties of the entire semiconductor material to be varied in response thereto; and
terminating said heating of the treated semiconductor surface.

20. A process as recited in claim 19, wherein the surface of said semiconductor is heated sufficiently to cause the activating of the implanted dopant to form a semiconductor having a shallow junction of less than 0.1mm.

21. A process as recited in claim 19 or claim 20, further comprising:
using temperature measuring means;
measuring continuously the surface temperature of the semiconductor material as it is exposed to said pulsating ultraviolet light; and
terminating said heating of the treated semiconductor surface when the surface area has been completely covered.

22. A process as recited in claim 21, wherein the heating of the surface of the treated semiconductor material is terminated when the surface temperature of the semiconductor is heated to a temperature of 800°C to 1200°C.

23. A process as recited in claim 21, wherein the heating of the surface of the treated semiconductor material is terminated when the surface temperature of the semiconductor is heated to a temperature of 1050°C.

24. A process as recited in claim 19, wherein the said ultraviolet light is pulsated at a rate between once per second and 1000 times per second.

25. A process as recited in claim 19, wherein said ultraviolet light is pulsated at a rate between once per second and 10 times per second.

## Patentansprüche

1. Verfahren zum Behandeln einer Oberfläche (17) umfassend:
Verwenden eines beabstandeten Paares aus einer Kombinations-Flüssigkeitsemitter-(35A) und -Elektrodeneinrichtung (35) und einer Kombinations-Flüssigkeitsrezeptor- (36A) und -Elektrodeneinrichtung (36);
Strömenlassen eines feinen Flüssigkeitsstroms (16) zwischen dem Paar von Elektrodeneinrichtungen (35, 36) mit einem ausreichenden Druck in einer ziemlich schmalen, geradlinigen und fokussierten Konfiguration, um die Ausbildung einer dünnen vorkonditionierenden Flüssigkeitsdampfwolke (23) zu veranlassen, die den fließenden feinen Flüssigkeitsstrom umgibt;
Einrichten einer elektrischen Spannungspotentialdifferenz zwischen der Elektrodeneinrichtung mit einer ausreichend hohen Spannung, um einen elektrischen Strom dazu zu bringen, durch die Flüssigkeitsdampfwolke zu fließen, um zunächst dort ein Plasma geringer Dichte zu erzeugen, welches ausreicht, daß Energie von ihm in den fließenden Flüssigkeitsstrom gelangt und diesen ausreichend erhitzt, so daß er ansprechend auf das Plasma geringer Dichte ionisiert und in ein Plasma hoher Dichte umgewandelt wird;
Verwenden einer Plasmaeinschnüranordnung (14), die über ein Kabel (15) mit einer Plasmasteueranordnung (13) gekoppelt ist, wobei die Kombinations-Flüssigkeitsemitter- und -Elektrodeneinrichtung und die Kombinations-Flüssigkeitsrezeptor- und -Elektrodeneinrichtung im Inneren der Plasmaeinschnüranordnung gelagert sind und mit der Plasmasteueranordnung gekoppelt sind;
Bewegen der Steueranordnung in die Nähe der zu behandelnden Oberfläche; und
Bewegen der Plasmaeinschnüranordnung relativ zu der zu behandelnden Oberfläche, um die Oberfläche hochintensiven, nicht-kohärentem Ultraviolettlicht auszusetzen, welches aus dem hochdichten Plasma abstrahlt.

2. Verfahren nach Anspruch 1, bei dem das Behandeln Glassieren ist und die Oberfläche eine Oberfläche aus der Gruppe Metall und Keramiken ausgewählt ist.

3. Verfahren nach Anspruch 1, bei dem die Behandlung Reinigen ist, um Substanzen von der Oberfläche zu lösen.

4. Verfahren nach Anspruch 1, bei dem die Behandlung ein Markieren der Oberfläche ist.

5. Vorrichtung zum Behandeln einer Oberfläche (17) umfassend:
ein beabstandetes Paar aus einer Kombinations-Flüssigkeitsemitter- (35A) und -Elektrodeneinrichtung (35) und einer Kombinations-Flüssigkeitsrezeptor- (36A) und -Elektrodeneinrichtung (36);
eine Einrichtung zum Erzeugen eines feinen Flüssigkeitsstroms (16) zwischen dem Paar von Elektrodeneinrichtungen bei ausreichendem Druck in einer ziemlich schmalen, geradlinigen und fokussierten Konfiguration, um die Ausbildung einer dünnen vorkonditionierenden Flüssigkeitsdampfwolke (23) zu veranlassen, die den feinen Flüssigkeitsstrom umgibt;
eine Entladungseinrichtung zum Erzeugen einer elektrischen Spannungspotentialdifferenz zwischen den Elektrodeneinrichtungen mit ausreichend hoher Spannung, um zu veranlassen, daß ein elektrischer Strom durch die Flüssigkeitsdampfwolke fließt, so daß dort herum zu Beginn ein Plasma geringer Dichte entsteht, ausreichend, damit Energie aus ihm heraus in den Flüssigkeitsstrom gelangt, um diesen so stark zu erhitzen, daß er ionisiert und ansprechend auf das Plasma geringer Dichte in ein Plasma hoher Dichte umgewandelt wird;
eine Plasmaeinschnüranordnung (14) zum Aufnehmen des Plasmas hoher Dichte, wobei die Plasmaeinschnüranordnung eine Vakuumkammereinrichtung (18) aufweist zum Begrenzen des Plasmas, wobei die Kombinations-Flüssigkeitsemitter- und -Elektrodeneinrichtung und die Kombinations-Flüssigkeitsrezeptor- und Elektrodeneinrichtung im Inneren der Vakuumkammereinrichtung gelagert sind;
eine Plasmasteueranordnung (13) zum Liefern der elektrischen Spannung und der Flüssigkeit an die Plasmaeinschnüranordnung;
ein flexibles Kabel (15) zum Koppeln der Plasmasteueranordnung mit der Plasmaeinschnüranordnung;
eine Einrichtung zum Lagern der Plasmaeinschnüranordnung relativ zu der Plasmasteueranordnung; und
eine Einrichtung zum beweglichen Aufnahmen der Plasmasteueranordnung relativ zu der zu behandelnden Oberfläche.

6. Vorrichtung nach Anspruch 5, bei der die Kombinations-Flüssigkeitsemitter-Elektrodeneinrichtung und Kombinations-Flüssigkeitsrezeptor- und -Elektrodeneinrichtung jeweils aufweisen:
ein Innenrohr aus einem elektrisch leitenden Material, so daß elektrischer Strom hindurchfließen kann;
eine in Fluidverbindung mit dem Innenrohr stehende Einrichtung zum Ermöglichen einer Flüssigkeitsverbindung zwischen dem Innenrohr und dem Flüssigkeitsstrom; und
ein Außenrohrelement mit einer Düseneinrichtung, die in Fluidverbindung mit dem Rohr steht.

7. Vorrichtung nach Anspruch 5, umfassend eine Einrichtung zum Drehen der Plasmaeinschnüranordnung (514).

8. Vorrichtung (809) zum Behandeln der Oberfläche eines Objekts (812) umfassend:
eine Plasmaeinschnüreinrichtung (810) zum Schaffen einer Quelle für inkohärentes Ultraviolettlicht ausreichender Stärke zum Behandeln der Oberfläche, einschließlich einer Plasmakammereinrichtung (832) zum Eingrenzen des Plasmas;
eine optische Einrichtung (890) zum Leiten des von der Plasmaeinschnüreinrichtung (810) erzeugten inkohärenten Ultraviolettlichts in Richtung auf die zu behandelnde Oberfläche;
eine Einrichtung zum Belichten des Objekts (812) mit dem von der optischen Einrichtung (890) kommenden inkohärenten Ultraviolettlicht; und
eine Gaskammereinrichtung (818) zum Eingrenzen der Plasmakammereinrichtung (832) und des Objekts (812).

9. Vorrichtung nach Anspruch 8, bei der die optische Einrichtung mehrere Elemente aufweist, die die Plasmaeinschnüranordnung (840) derart umgebend angeordnet sind, daß sie das von ihr kommende Licht durch ein Auslaßport (P) in der Gaskammereinrichtung lenken.

10. Vorrichtung nach Anspruch 9, bei der die Elemente Linsen (820, 834, 836) und reflektierende Glieder (830) enthalten.

11. Vorrichtung nach Anspruch 8, bei der die Einrichtung zum Belichten des Objekts (812) mit dem inkohärenten Ultraviolettlicht eine Einrichtung (813, 814) aufweist, um das Objekt (812) eine vorbestimmte Zeitspanne zu exponieren.

12. Vorrichtung nach Anspruch 8, bei der die Gaskammereinrichtung (818) außerdem die optische Einrichtung (890) einschließt.

13. Vorrichtung nach Anspruch 8, bei der ein inertes Gas sich im Inneren der Gaskammereinrichtung (818) befindet.

14. Verfahren zum Behandeln einer Oberfläche eines Objekts (805), umfassend:
Verwenden einer Plasmaeinschnüreinrichtung (810) zum Schaffen einer Quelle für inkohärentes Ultraviolettlicht;
Verwenden einer optischen Einrichtung, um das inkohärente Ultraviolettlicht auf das Objekt (812) zu richten;
Verwenden einer Einrichtung zum Belichten des Objekts (812) mit dem inkohärenten Ultraviolettlicht von der optischen Einrichtung (890);
Eingrenzen der Plasmakammereinrichtung (832) und des Objekts (812) in einer Gaskammereinrichtung (818).

15. Verfahren nach Anspruch 14, bei dem das Verwenden der Einrichtung zum Belichten des Objekts (812) mit dem inkohärenten Ultraviolettlicht das Bewegen des Objekts (810) im Inneren der Gaskammereinrichtung (818) beinhaltet.

16. Verfahren nach Anspruch 14, bei dem das Verwenden der Einrichtung zum Belichten des Objekts (812) mit dem inkohärenten Ultraviolettlicht das Belichten des Objekts (812) für eine vorbestimmte Zeitspanne beinhaltet.

17. Verfahren nach Anspruch 14, gekennzeichnet durch das Eingrenzen der optischen Einrichtung (890) im Inneren der Gaskammereinrichtung.

18. Verfahren nach Anspruch 14, weiterhin umfassend das Einbringen von inertem Gas in die Gaskammereinrichtung (818), um die Verringerung der Impedanz gegenüber dem Durchlauf des inkohärenten ultravioletten Lichts durch sie hindurch zu unterstützen.

19. Verfahren zum Behandeln der Oberfläche eines Halbleitermaterials (819), um dessen Leitungseigenschaften zu variieren, umfassend:
Verwenden einer Plasmaeinschnüreinrichtung zum Bilden von inkohärentem Ultraviolettlicht ausreichender Stärke, damit die Leitungseigenschaften praktisch der gesamten ebenen Oberfläche des Halbleitermaterials gleichmäßig variiert werden, wobei das Bilden die Verwendung eines beabstandeten Paares aus einer Kombinations-Flüssigkeitsemitter- (35A) und -Elektrodeneinrichtung (35) und einer Kombinations-Flüssigkeitsrezeptor- (36A) und -Elektrodeneinrichtung (36) umfaßt sowie das Ausbilden eines feinen Flüssigkeitsstroms zwischen dem Paar von Elektrodeneinrichtungen (35, 36) mit ausreichendem Druck in einer ziemlich schmalen, geradlinigen und fokussierten Konfiguration, damit sich dort herum eine dünne vorkonditionierende Flüssigkeitsdampfwolke (23) ausbildet, die den feinen Flüssigkeitsstrom unter Druck umgibt;
Bilden einer elektrischen Spannungspotentialdifferenz zwischen den Elektrodeneinrichtungen (35, 36) mit einer ausreichend hohen Spannung, um einen elektrischen Stromfluß durch die Flüssigkeitsdampfwolke (23) zu veranlassen und damit die anfängliche Erzeugung von Plasma geringer Dichte entlang der Wolke, ausreichend, um aus ihm Energie in den Flüssigkeitsstrom gelangen zu lassen, damit er ausreichend erhitzt wird, um ionisiert und ansprechend auf das Plasma geringer Dichte in ein Plasma hoher Dichte umgewandelt zu werden und so hochintensives inkohärentes Ultraviolettlicht zu erzeugen;
Richten des Ultraviolettlichts auf die gesamte Oberfläche des Halbleitermaterials (812), welches aus einem Halbleitermaterial besteht, das einen implantierten Dotierstoff für die Erhitzung über die gesamte Oberfläche aufweist;
wiederholtes Pulsieren des Ultraviolettlichts mit einer Geschwindigkeit von mindestens einmal pro Sekunde, um die Leitungseigenschaften des gesamten Halbleitermaterials ansprechend darauf zu variieren; und
Beendigen des Erhitzens der behandelten Halbleiteroberfläche.

20. Verfahren nach Anspruch 19, bei dem die Oberfläche des Halbleiters soweit erhitzt wird, daß die Aktivierung des implantierten Dotierstoffs zur Bildung eines Halbleiters veranlaßt wird, der einen flachen Übergang von weniger als 0,1 mm besitzt.

21. Verfahren nach Anspruch 19 oder 20, weiterhin umfassend:
Verwenden einer Temperaturmeßeinrichtung;
kontinuierliches Messen der Oberflächentemperatur des Halbleitermaterials, wenn dies dem pulsierenden Ultraviolettlicht ausgesetzt wird; und
Beenden des Erhitzens der behandelten Halbleiteroberfläche dann, wenn der Oberflächenbereich vollständig abgedeckt wurde.

22. Verfahren nach Anspruch 21, bei dem das Erhitzen der Oberfläche des behandelten Halbleitermaterials dann abgeschlossen wird, wenn die Oberflächentemperatur des Halbleiters auf eine Temperatur von 800°C bis 1200°C erwärmt wurde.

23. Verfahren nach Anspruch 21, bei dem das Erwärmen der Oberfläche des behandelten Halbleitermaterials dann beendet wird, wenn die Oberflächentemperatur des Halbleiters auf einer Temperatur von 1050°C erwärmt ist.

24. Verfahren nach Anspruch 19, bei dem das Ultraviolettlicht mit einer Geschwindigkeit von zwischen einmal pro Sekunde und 1000-mal pro Sekunde gepulst wird.

25. Verfahren nach Anspruch 19, bei dem das Ultraviolettlicht mit einer Geschwindigkeit zwischen einmal pro Sekunde und 10-mal pro Sekunde pulsiert wird.

## Revendications

1. Procédé pour traiter une surface (17), comprenant les étapes suivantes :
utiliser une paire composée d'un émetteur de liquide (35A) et de moyens d'électrode (35) combinés, et d'un récepteur de liquide (36A) et de moyens d'électrode (36) combinés, espacés les uns des autres;
faire s'écouler entre ladite paire de moyens d'électrode (35, 36) un fin courant de liquide (16) sous une pression suffisante en une configuration pratiquement étroite, rectiligne et focalisée, pour provoquer la formation autour de ce courant d'un nuage ténu de préconditionnement de vapeur de liquide (23) entourant le fin courant de liquide en écoulement;
établir entre lesdits moyens d'électrode une différence de potentiel de tension électrique d'une tension suffisamment élevée pour amener un courant électrique à s'écouler à travers ledit nuage de vapeur de liquide pour établir initialement en son sein un plasma de faible densité suffisant pour qu'il en émane de l'énergie qui passe dans ledit courant de liquide en écoulement afin de le chauffer suffisamment pour qu'il devienne ionisé et qu'il soit converti en un plasma de densité élevée en réponse audit plasma de faible densité;
utiliser un ensemble de striction de plasma (14) couplé par l'intermédiaire d'un câble (15) à un ensemble de commande de plasma (13) dans lequel lesdits émetteur de liquide et moyens d'électrode combinés et lesdits récepteur de liquide et moyens d'électrode combinés sont montés à l'intérieur dudit ensemble de striction de plasma et sont couplés audit ensemble de commande de plasma;
déplacer ledit ensemble de commande à proximité de la surface à traiter; et
déplacer ledit ensemble de striction de plasma par rapport à la surface à traiter pour exposer la surface à une lumière ultraviolette incohérente de forte intensité rayonnant dudit plasma à densité élevée.

2. Procédé selon la revendication 1, dans lequel ledit traitement est un glaçage et la surface est une surface choisie dans le groupe constitué par un métal et des céramiques.

3. Procédé selon la revendication 1, dans lequel ledit traitement est un nettoyage pour déloger des substances de la surface.

4. Procédé selon la revendication 1, dans lequel ledit traitement est un marquage de la surface.

5. Appareil pour traiter une surface (17), comprenant :
une paire composée d'un émetteur de liquide (35A) et de moyens d'électrode (35) combinés, et d'un récepteur de liquide (36A) et de moyens d'électrode (36) combinés, espacés les uns des autres;
des moyens pour faire s'écouler entre ladite paire de moyens d'électrode un fin courant de liquide (16) sous une pression suffisante en une configuration pratiquement étroite, rectiligne et focalisée, pour provoquer la formation autour de ce courant d'un nuage ténu de préconditionnement de vapeur de liquide (23) entourant le fin courant de liquide en écoulement;
des moyens de décharge pour établir entre lesdits moyens d'électrode une différence de potentiel de tension électrique d'une tension suffisamment élevée pour amener un courant électrique à s'écouler à travers ledit nuage de vapeur de liquide pour établir initialement en son sein un plasma de faible densité suffisant pour qu'il en émane de l'énergie qui passe dans ledit courant de liquide en écoulement afin de le chauffer suffisamment pour qu'il devienne ionisé et pour qu'il soit converti en un plasma de densité élevée en réponse audit plasma de faible densité;
un ensemble de striction de plasma (14) pour contenir ledit plasma à densité élevée, ledit ensemble de striction de plasma comprenant des moyens de chambre à vide (18) pour confiner ledit plasma, dans lequel lesdits émetteur de liquide et moyens d'électrode combinés et lesdits récepteur de liquide et moyens d'électrode combinés sont montés à l'intérieur desdits moyens de chambre à vide;
un ensemble de commande de plasma (13) pour fournir la tension électrique et le liquide audit ensemble de striction de plasma;
un câble flexible (15) pour coupler ledit ensemble de commande de plasma audit ensemble de striction de plasma;
des moyens pour monter ledit ensemble de striction de plasma de façon mobile par rapport audit ensemble de commande de plasma; et
des moyens pour monter ledit ensemble de commande de plasma de façon mobile par rapport à la surface à traiter.

6. Appareil selon la revendication 5, dans lequel lesdits émetteur de liquide et moyens d'électrode combinés et lesdits récepteur de liquide et moyens d'électrode combinés comprennent chacun :
un tube intérieur composé d'un matériau conducteur de l'électricité pour permettre au courant électrique de s'écouler à travers lui;
des moyens raccordés en communication de fluide audit tube intérieur pour permettre une communication de liquide entre le tube intérieur et le courant de liquide; et
un élément tubulaire extérieur ayant des moyens de buse raccordés en communication fluide avec ledit tube.

7. Appareil selon la revendication 5, comprenant en outre des moyens pour faire tourner ledit ensemble de striction de plasma (514).

8. Appareil (809) pour traiter la surface d'un objet (812), comprenant :
des moyens de striction de plasma (810) pour établir une source de lumière ultraviolette incohérente d'intensité suffisamment élevée pour traiter la surface, comprenant des moyens de chambre à plasma (832) pour contenir ledit plasma;
des moyens optiques (890) pour guider ladite lumière ultraviolette incohérente produite par lesdits moyens de striction de plasma (810) vers la surface à traiter;
des moyens pour exposer ledit objet (812) à ladite lumière ultraviolette incohérente en provenance desdits moyens optiques (890); et
des moyens de chambre à gaz (818) pour confiner lesdits moyens de chambre à plasma (832) et ledit objet (812).

9. Appareil selon la revendication 8, dans lequel lesdits moyens optiques comprennent une multiplicité d'éléments disposés en entourant ladite striction de plasma (840) pour diriger la lumière en provenant à travers un orifice de sortie (P) dans lesdits moyens de chambre à gaz.

10. Appareil selon la revendication 9, dans lequel lesdits éléments comprennent des lentilles (820, 834, 836) et des éléments réfléchissants (830).

11. Appareil selon la revendication 8, dans lequel lesdits moyens pour exposer ledit objet (812) à ladite lumière ultraviolette incohérente comprennent des moyens (813, 814) pour exposer ledit objet (812) pendant une période de temps prédéterminée.

12. Appareil selon la revendication 8, dans lequel lesdits moyens de chambre à gaz (818) confinent en outre lesdits moyens optiques (890).

13. Appareil selon la revendication 8, dans lequel un gaz inerte est disposé à l'intérieur desdits moyens de chambre à gaz (818).

14. Procédé pour traiter une surface d'un objet (812), comprenant les étapes suivantes :
utiliser des moyens de striction de plasma (810) pour établir une source de lumière ultraviolette incohérente;
utiliser des moyens optiques pour diriger ladite lumière ultraviolette incohérente en direction dudit objet (812);
utiliser des moyens pour exposer ledit objet (812) à ladite lumière ultraviolette incohérente en provenance desdits moyens optiques (890);
confiner lesdits moyens de chambre à plasma (832) et ledit objet (812) dans des moyens de chambre à gaz (818).

15. Procédé selon la revendication 14, dans lequel l'utilisation desdits moyens pour exposer ledit objet (812) à ladite lumière ultraviolette incohérente comprend le déplacement dudit objet (812) à l'intérieur desdits moyens de chambre à gaz (818).

16. Procédé selon la revendication 14, dans lequel l'utilisation desdits moyens pour exposer ledit objet (812) à ladite lumière ultraviolette incohérente comprend l'exposition dudit objet (812) pendant une période de temps prédéterminée.

17. Procédé selon la revendication 14, comprenant en outre le confinement desdits moyens optiques (890) à l'intérieur desdits moyens de chambre à gaz.

18. Procédé selon la revendication 14, comprenant en outre la disposition d'un gaz inerte à l'intérieur desdits moyens de chambre à gaz (818) pour aider à réduire l'impédance au passage de ladite lumière ultraviolette incohérente les traversant.

19. Procédé pour traiter la surface d'un matériau semiconducteur (812) pour faire varier ses propriétés de conductivité, comprenant les étapes suivantes :
utiliser des moyens de striction de plasma pour établir une lumière ultraviolette incohérente d'une intensité suffisamment élevée pour faire varier uniformément les propriétés de conductivité de pratiquement toute la surface plane du matériau semi-conducteur, ledit établissement comprenant les étapes suivantes : utiliser une paire composée d'un émetteur de liquide (35A) et de moyens d'électrode (35) combinés, et d'un récepteur de liquide (36A) et de moyens d'électrode (36) combinés, espacés les uns des autres; faire s'écouler entre ladite paire de moyens d'électrode (35, 36) un fin courant de liquide sous une pression suffisante en une configuration pratiquement étroite, rectiligne et focalisée pour provoquer la formation autour de ce courant d'un nuage ténu de préconditionnement de vapeur de liquide (23) entourant le fin courant de liquide sous pression en écoulement; établir une différence de potentiel de tension électrique entre lesdits moyens d'électrode (35, 36) d'une tension suffisamment élevée pour faire s'écouler un courant électrique à travers ledit nuage de vapeur de liquide (23) pour établir initialement le long de ce nuage un plasma de faible densité suffisant pour qu'il en émane de l'énergie qui passe dans ledit courant de liquide en écoulement afin de le chauffer suffisamment pour qu'il devienne ionisé et qu'il soit converti en un plasma de densité élevée en réponse audit plasma de faible densité afin de produire une lumière ultraviolette incohérente de forte intensité;
diriger ladite lumière ultraviolette en direction de toute la surface du matériau semi-conducteur (812) constitué par un matériau semi-conducteur ayant un dopant implanté pour en chauffer la totalité de la surface;
pulser ladite lumière ultraviolette de façon répétitive à une fréquence d'au moins une fois par seconde pour amener les propriétés de conductivité du matériau semi-conducteur tout entier à varier en réponse à celle-ci; et
terminer ledit chauffage de la surface du semi-conducteur traitée.

20. Procédé selon la revendication 19, dans lequel la surface dudit semi-conducteur est chauffée suffisamment pour provoquer l'activation du dopant implanté afin de former un semi-conducteur ayant une jonction peu profonde de moins de 0,1 mm.

21. Procédé selon la revendication 19 ou la revendication 20, comprenant en outre les étapes suivantes :
utiliser des moyens de mesure de température;
mesurer de façon continue la température de surface du matériau semi-conducteur lorsqu'elle est exposée à ladite lumière ultraviolette pulsatoire; et
terminer ledit chauffage de la surface du semi-conducteur traitée lorsque la totalité de la surface a été complètement couverte.

22. Procédé selon la revendication 21, dans lequel le chauffage de la surface du matériau semi-conducteur traité est terminé lorsque la température de surface du semi-conducteur est chauffée à une température de 800°C à 1200°C.

23. Procédé selon la revendication 21, dans lequel le chauffage de la surface du matériau semi-conducteur traité est terminé lorsque la température de surface du semi-conducteur est chauffée à une température de 1050°C.

24. Procédé selon la revendication 19, dans lequel ladite lumière ultraviolette est pulsée à une fréquence comprise entre une fois par seconde et 1000 fois par seconde.

25. Procédé selon la revendication 19, dans lequel ladite lumière ultraviolette est pulsée à une fréquence comprise entre une fois par seconde et 10 fois par seconde.
